# EUROPÄISCHE PATENTSCHRIFT

(11) **EP 4 089 377 B1**
(45) Veröffentlichungstag und Bekanntmachung des Hinweises auf die Patenterteilung: **24.04.2024**
(21) Anmeldenummer: 21173456.1
(22) Anmeldetag: 12.05.2021
(51) Int. Cl.: G01H 1/00

(54) **VERFAHREN ZUR ZUSTANDSÜBERWACHUNG EINER VORRICHTUNG UND BAUGRUPPE**
METHOD FOR MONITORING THE STATE OF A DEVICE AND ASSEMBLY
PROCÉDÉ DE SURVEILLANCE DE L'ÉTAT D'UN DISPOSITIF ET MODULE

(43) Veröffentlichungstag der Anmeldung: 16.11.2022
(73) Patentinhaber: Siemens Aktiengesellschaft, 80333 München (DE)
(72) Erfinder: Zettner, Jürgen, 90587 Veitsbronn (DE); Bögler, Marco, 91083 Baiersdorf (DE)
(74) Vertreter: Siemens Patent Attorneys

(56) Entgegenhaltungen:
- EP-A2- 1 528 377
- US-A- 4 885 707
- US-A1- 2003 074 159
- Siemens: "SIPLUS CMS1200 - SM 1281 Technical Slides", , 1. Januar 2016 (2016-01-01), XP055846826, Gefunden im Internet: URL:https://assets.new.siemens.com/siemens /assets/api/uuid:2b18b2d1-dbc1-4e16-8f67-e 63c974b8220/siplus-cms1200-tech-en.pdf [gefunden am 2021-10-01]

## Beschreibung

Die Erfindung betrifft ein Verfahren zur Zustandsüberwachung einer Vorrichtung durch eine Messung eines eine Zustandsgröße der Vorrichtung repräsentierendes zeit- und wert-kontinuierlichen Analog-Signals, wobei das Analog-Signal zu Abtastzeiten innerhalb eines Messintervalls mit einem Analog-Digital-Umsetzer in ein Digital-Signal umgesetzt wird, wobei der Analog-Digital-Umsetzer innerhalb eines Messbereichs betrieben wird, wobei für den Fall, dass das Analog-Signal den Messbereich überschreitet, werden über den Messbereich hinausgehende Signalanteile des Analog-Signals in Digital-Signal abgeschnitten, wobei anschließend auf das Digital-Signal eine Spektralanalyse angewendet wird, um zu ermitteln, welche Frequenzanteile das Analog-Signal in einem Frequenzspektrum umfasst, und anhand eines Vergleichs mit den auftretenden Frequenzanteilen und bekannten Schadfrequenzen auf eine Störung der Vorrichtung zu schließen.

Ebenso betrifft die Erfindung eine elektronische Baugruppe, ausgestaltet zur Zustandsüberwachung einer Vorrichtung, umfassend eine Eingangsschaltung zur Messung eines eine Zustandsgröße der Vorrichtung repräsentierendes zeit- und werte-kontinuierlichen Analog-Signals, einen Analog-Digital-Umsetzer, welcher das Analog-Signal zu Abtastzeitpunkten innerhalb eines Messintervalls abtastet und in ein Digital-Signal umsetzt, wobei der Analog-Digital-Umsetzer ausgestaltet ist, innerhalb eines Messbereichs zu arbeiten, wobei für den Fall, dass das Analog-Signal den Messbereich überschreitet, über den Messbereich hinausgehende Signalanteile des Analog-Signals im Digital-Signal abzuschneiden, ein Mittel zur Sprektalanalyse um auf das Digital-Signal eines Spektralanalyses anzuwenden, um zu ermitteln, welche Frequenzanteile das Analog-Signal in einem Frequenzspektrum umfasst, und anhand eines Vergleiches mit den auftretenden Frequenzanteilen und bekannten Schadfrequenzen auf eine Störung der Vorrichtung zu schließen.

Ein derartiges Verfahren und eine derartige Baugruppe ist beispielsweise aus der Betriebsanleitung "Siemens, SIPLUS SM 1281, Condition Montioring System SM 1281 Condition Monitoring, 06/2016, AE536912747-AB", bekannt.

Zusätzlich zu der Betriebsanleitung sind Folien über das System SIPLUS CMS 1200 bekannt. Siemens: "SI PLUS CMS1200 - SM 1281 Technical Slides", 1. Januar 2016 (2016-01-01), XP055846826, Gefunden im Internet: URL:https://assets.new.siemens.com/siemens/assets/api/uuid:2b 18b2d1- dbc1-4e16-8f67-e63c974b8220/siplus-cms1200-tech-en.pdf [gefunden am 2021-10-01].

Die EP 1 528 377 A2 offenbart einen tragbaren Schwingungsanalysator.

Die US 4 885 707 A offenbart ein Verfahren für eine vorausschauende Wartung von Maschinen, dazu wird eine Vorrichtung zum Aufzeichnen von Schwingungsdaten genutzt.

Die US 2003/074159 A1 zeigt ein Verfahren um einen Gesundheitsindex z.B. von Flugzeugkomponenten zu ermitteln.

Im Sinne der Erfindung ist unter Zustandsüberwachung einer Vorrichtung eine vorbeugende Überwachung von Maschinen oder Anlagen zu verstehen, um größere Schäden oder Stillstandszeiten zu vermeiden.

Eine Diagnose von beispielsweise Lagerschilden wird anhand einer Schwingungsdiagnose durch eine Frequenzanalyse durchgeführt. Das Prinzip einer Frequenzanalyse besteht darin, ein Signal aus dem Zeitbereich durch eine Spektralanalyse in den Frequenzbereich zu überführen. Eine gebräuchliche mathematische Methode dazu ist die Fourier-Transformation.

Bei den bekannten Verfahren und Baugruppen ist es von Nachteil, dass beispielsweise bei einer Vibrationsanalyse, insbesondere bei stark beschädigten Lagern, deren Stärke der Schädigung diagnostiziert werden soll, das Sensorsignaleingänge kurzzeitig in eine Sättigung gehen, weil ein oberer/unterer Messeingangsbereich durch real auftretende Schwingungsamplituden erreicht wird. Andere Gründe für hohe Schwingungsamplituden können sich verändernde Maschinenstrang-Ausrichtungen und auftretende Unwuchten durch fehlerhaft gewordene Komponenten oder durch Prozesseinflüsse sein. Dadurch können Sensorsignal- und Messeingänge des digitalisierenden Systems übersteuert werden, weil die Auslegungs-Messbereiche durch real auftretende Fehler überschritten werden.

Sensorsignal-Sättigungen kommen auch in einer Stromsignaturanalyse vor, vor allem wenn Stromwandler mit Ferritkernen, aber auch Hall-Sensor oder Rogowski-Strommesseingänge bei hohen oder überhöhten Anlaufströmen von elektrischen Maschinen in die Sättigung gehen oder wenn kritische Fehlerströme in Einzelzweigen eines Dreileitersystems erzeugen, für deren Stärke die Messstrecke nicht ausgelegt war.

Bei den nach dem Stand der Technik bekannten Vorrichtungen und Verfahren ist es von Nachteil, dass ein erfasstes Signal mit abgeschnittenen Signalanteilen, welche insbesondere durch eine Übersteuerung der Messeingänge hervorgerufen werden, zusätzliche störende Frequenzen in einem später auszuwertenden Frequenzspektrum hervorrufen.

Es ist Aufgabe der vorliegenen Erfindung ein Verfahren anzugeben, welches die teiweise Übersteuerung von Zustandsüberwachungssensorsignalen erkennt und ein Maß für die Übersteuerung bzw. ein Maß für eine Signalgüte liefert.

Die Aufgabe wird für das eingangs genannte Verfahren dadurch gelöst, dass für den Fall, dass zu einem Abtastzeitpunkt das über den Messbereich hinausgehende Analog-Signal im Digital-Signal abgeschnitten wird, dieses Ereignis erfasst wird, und als eine Anzahl ermittelt wird, wobei eine Signalgüte als Quotient aus der Anzahl zu einer Gesamtabtastzahl innerhalb des Messintervalls bereitgestellt wird, und die Signalgüte dazu verwendet wird, zu beurteilen, ob die bekannten Schadfrequenzen noch aus dem ermittelten Frequenzanteilen des Frequenspektrums erkennbar sind, obwohl es durch mögliche abgeschnittene Signalanteile zu zusätzlichen Übersteuerungsanteilen in dem Frequenzspektrum gekommen ist.

Das erfindungsgemäße Verfahren sieht vor, zu jedem Abtastzeitpunkt zu ermitteln, ob ein Messbereich übersteuert wurde und dadurch ein abgeschnittenes Signal entstanden ist. Eine Anzahl an abgeschnittenen Signalereignissen wird dann in Bezug gesetzt zu der Gesamtanzahl der Abtastungen. Es ist von Vorteil, wenn die Signalgüte nicht nur ermittelt und einem überlagerten System oder einer App kommuniziert wird, sondern auch zum optimierten Einsatz von Signalkorrekturverfahren herangezogen wird.

Demnach ist es in einer optimierten Ausgestaltung des Verfahrens vorgesehen, mit einen Signalkorrekturverfahren das Digital-Signal zu korrigieren bzw. zu schätzen, wodurch die durch das Abschneiden entstandenen zusätzlichen Übersteuerungsanteile dadurch in einem Schätz-Signal elliminiert oder zumindest reduziert werden, wobei die bekannten Schadfrequenzen noch erkannt werden und in einer Übertragungsfunktion abgebildet werden, wobei in Abhängigkeit von der Signalgüte die Übertragungsfunktion bis zu einen vorgebbaren Grenzwert von der Signalgüte weiter genutzt wird.

Da verfahrensgemäß nun laufend die Anzahl von Sampels außerhalb oder an den Rändern eines gewissen Messbereiches, welche auch als Lowerlevel und Upperlevel definiert sind, erfasst werden, kann mit dieser Kenntnis eine Signalgüte bereitgestellt werden. Die genannten Grenzen können definiert sein, als diejenigen mit welchen eine gewisse Linearität des Messkanals sicher gewährleistet ist, diejenigen die maximal im Analog-Digital-Wandler oder eines Verstärkers nutzbar sind (z.B. Betriebsspannungen-Abstand zu den Betriebsspannungen) oder diejenigen, welche sicher einen Betrieb zu einer gewissen einstellbaren Anwendungsmessgrenze erlauben.

Als voller Messbereich (auch als Vollausschlag bezeichnet) eines A/D-Wandlers wird die größte Signalamplitude bezeichnet, welche an die Eingänge des Wandlers angelegt werden kann, bevor es am Digitalausganz zum "Clippen" kommt. Beim Vollausschlag nutzt der Ausgang die minimalen und die maximalen Codes des A/D-Wandlers.

Im Sinne der Erfindung wird unter Clipping verstanden, die überschüssigen Signalanteile werden von der verarbeitenden Hard- oder Software "abgeschnitten". Da die meisten Schadensarten in einem Spektrum in einem Auftreten typischer Schadensfrequenzen bzw. typische Muster von Schadensfrequenzen erkennbar sind, ist es von Nachteil wenn in diesem zu analysierenden Spektrum zusätzlich noch Frequenzanteile erscheinen, welche durch Clipping hervorgerufen wurden.

Das Verfahren ermöglicht es jetzt jedoch durch die ermittelte Signalgüte eine Beobachtung und Auswertung der Frequenzanteile besser einzuschätzen. Werden z.B. durch real auftretende Amplituden die Schwinungen größer als der Messbereich, so kann die Information der Signalgüte dazu genutzt werden, die Bewertung der Frequenzanteile und/oder die Bewertung eines sich verschlechternden Zustandes der zu überwachenden Vorrichtung vorzunehmen.

Auch ist es vorteilhaft, wenn in Abhängigkeit von der Signalgüte die Übertragungsfunktion modifiziert wird.

Weiterhin ist es vorteilhaft, wenn in einer Lernphase in einem Gutzustand der Vorrichtung in Abhängigkeit von der Signalgüte eine Reihe von Übertragungsfunktionen gebildet und archiviert werden, wobei dann die Übertragungsfunktion im ursprünglichen Gutzustand einer überwachten Vorrichtung als Referenz dient.

Insbesondere im Hinblick auf ein geeignetes Schätzsignal um die durch das Clipping entstandenen Frequenzanteile durch die Übersteuerungsanteile zu reduzieren, ist es vorteilhaft, dass als Signalkorrekturverfahren ein Wiener-Filter verwendet wird. Wiener-Filter werden in Verfahren genutzt, die fehlende oder durch Rauschen verfälschte oder verzerrte Sampling-Werte versuchen zu rekonstruieren (schätzen). Obwohl der Wiener-Filter dazu dient, ein unbekanntes Original-Signal im Zeitbereich aus einem verrauschten und von einem LDI-System mit einer Übertragungsfunktion verzerrten und gemessenen Signal im Zeitbereich als bestmögliche Näherung Y zu schätzen, kann der Filter auch auf geclippte Signale angewendet werden.

Auch wird die eingangs genannte Aufgabe für die eingangs genannte elektronische Baugruppe dadurch gelöst, dass in der Baugruppe ein Detektionsmittel vorhanden ist, welches ausgestaltet ist, für den Fall, dass das zu einem Abtastzeitpunkt über den Messbereich hinausgehende Analog-Signal im Digital-Signal abgeschnitten wird, dieses Ereignis zu erfassen und in einen Zähler als eine Anzahl hochzuzählen, wobei eine Signalgüte-Auswerteeinrichtung vorhanden ist, welche eine Signalgüte als Quotient aus der Anzahl zu einer Gesamtabtastzahl innerhalb des Messintervalls bereitstellt, weiterhin aufweisend ein Entscheidungsmittel, welches ausgestaltet ist, anhand der Signalgüte zu beurteilen, ob die bekannten Schadfrequenzen noch aus den ermittelten Frequenzenanteilen des Frequenzspektrums erkennbar sind, obwohl es durch mögliche abgeschnittene Signalanteile zu zusätzlichen Übersteuerungsanteilen in den Frequenzspektrum gekommen ist.

Clippen erzeugt vor allem bei hohen Frequenzen Spektrallinien mit Amplituden bis zu 10 %. Dieses Verhalten, übertragen auf Lagerschadensanalyse bedeutet, dass Spektrallinien eingeblendet werden könnten, welche für einen Lagerschaden stehen. Es kommt entweder zu einer Fehlinterpretation ("falsch positiv"). Oder aber ein Lagerschaden wird als schwerwiegender als tatsächlich eingestuft, da die vorhandenen Linien und harmonischen von den Linien des Clippings überlagert werden. In einer Weiterbildung der Baugruppe weist diese ein Filtermittel auf, in welchem ein Signalkorrekturverfahren abläuft, welches das Digital-Signal korrigiert bzw. schätzt und die durch das Abschneiden entstandenen zusätzlichen Übersteuerungsanteile dadurch in einem Schätz-Signal eliminiert oder zumindest reduziert werden, wobei das Filtermittel weiterhin eine Übertragungsfunktion aufweist, welche die bekannten Schadfrequenzen noch abbildet, wobei das Filtermittel einen Eingang für die Signalgüte aufweist und das Filtermittel ausgestaltet ist, in Abhängigkeit von der Signalgüte die Übertragungsfunktion bis zu einen vorgebbaren Grenzwert weiter zu nutzen.

Bei Anwendung des Signalkorrekturverfahrens nehmen erwartbare falsch positiv Fehler ab, ein Messsystem könnte auch beispielsweise über den Auslegungsmessbereich hinaus in gewissen Frequenzbändern zuverlässiger arbeiten. Meßbare Schadfrequenzen die in einem Normalbetrieb d.h. alle Schadfrequenzen innerhalb der Messgrenzen (Signalgüte Q = 1) werden durch den Wiener-Filter erkannt und in der Übertragungsfunktion abgebildet. Treten nun geklippte Signale (Q < 1) auf, so soll die Übertragungsfunktion noch erhalten bleiben, d.h. Artefakte durch Clipping können zunächst weiter unterdrückt werden, eventuell schon vorhandene Lagerschadfrequenzen jedoch weiter übertragen werden. Das Verfahren zur Zustandsüberwachung bleibt in seiner Spektraldarstellung und auch Klassifikationsfunktionalitäten weitgehend erhalten.

Um das zu erreichen, ist es vorteilhaft, mit einem Anpassungsmittel innerhalb der Baugruppe, welches ausgestaltet ist, in Abhängigkeit von der Signalgüte die Übertragungsfunktion zu modifizieren.

Noch weiter optimiert werden kann die Baugruppe mit einem Lernmittel, welches ausgestaltet ist, in einer Lernphase in einem Gutzustand der Vorrichtung in Abhängigkeit von der Signalgüte eine Reihe von Übertragungsfunktionen zu bilden und zu archivieren, weiterhin ausgestaltet, die Übertragungsfunktion im ursprünglichen Gutzustand einer überwachten Vorrichtung als Referenz zu nehmen.

Vorteilhafterweise ist in dem Filtermittel ein Wiener-Filter implementiert.

Die Zeichnung zeigt ein Ausführungsbeispiel der Erfindung, dabei zeigt
- FIG 1: eine Baugruppe zur Zustandsüberwachung,
- FIG 2: die Baugruppe aus FIG 1 in einer Weiterbildung,
- FIG 3: das Prinzip einer Zustandsüberwachung einer Vorrichtung,
- FIG 4: ein Beispiel eines Spektrums mit Störfrequenzen,
- FIG 5: ein zu erfassendes Signal, welches in eine Messbereichsbegrenzung übergeht,
- FIG 6: ein Diagramm für eine spektrale Leistungsdichte,
- FIG 7: eine aus der spektralen Leistungdichte abgeleitete Übertragungsfunktion und
- FIG 8: ein mit einen Wiener-Filter geschätztes Signal im Gegensatz zu einem Ursprungssignal.

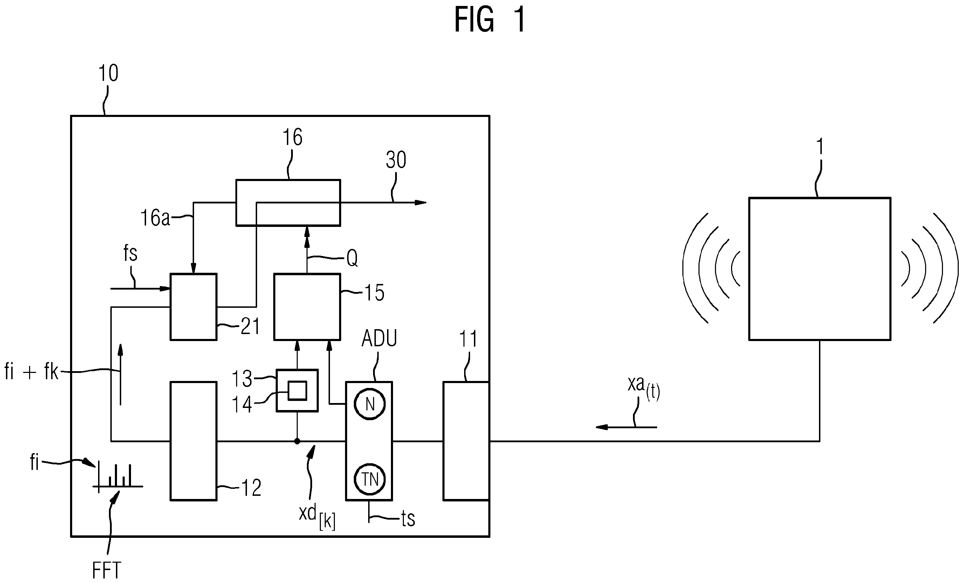

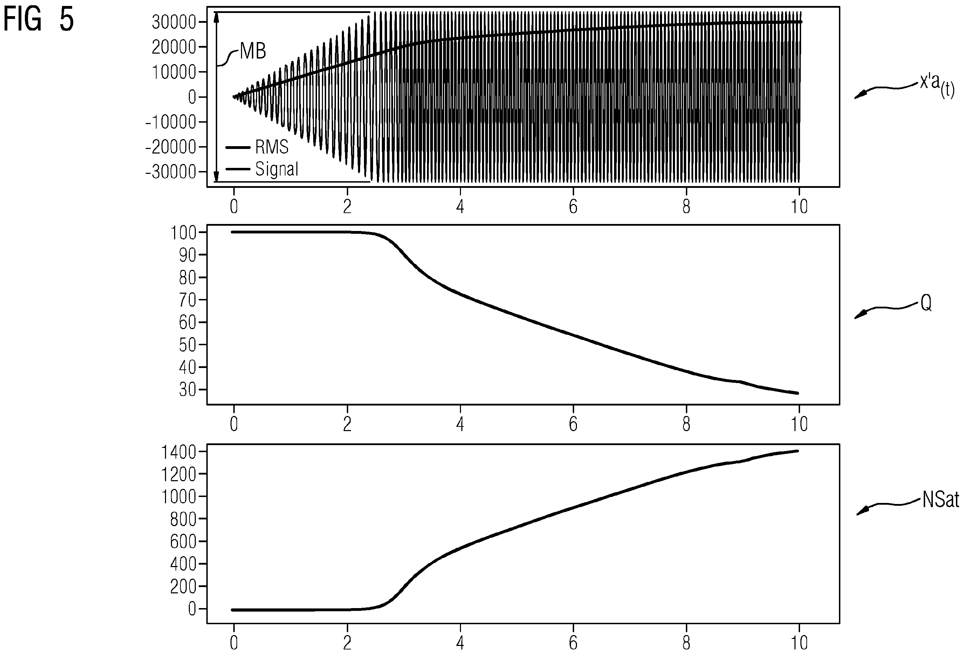

In FIG 1 ist eine Baugruppe 10 ausgestaltet zur Zustandsüberwachung einer Vorrichtung 1 abgebildet. Die Baugruppe 10 umfasst eine Eingangsschaltung 11 zur Messung eines eine Zustandsgröße der Vorrichtung 1 repräsentierendes zeit- und wert-kontinuierlichen Analog-Signal xa(t), einen Analog-Digital-Umsetzer ADU, welcher das Analog-Signal xa(t) zu Abtastzeitpunkten ts innerhalb eines Messintervalls Tn abtastet und in ein Digital-Signal xd[k] umsetzt, wobei der Analog-Digital-Umsetzer ADU ausgestaltet ist, innerhalb eines Messbereichs MB zu arbeiten, wobei für den Fall, dass das Analog-Signal xa(t) den Messbereich MB überschreitet, über den Messbereich MB hinausgehende Signalanteile des Analog-Signals xa(t) im Digital-Signal xd[k] abzuschneiden (sieh FIG 5). Weiterhin weist die Baugruppe 10 ein Mittel 12 zur Spektralanalyse auf, um auf das Digital-Signal xd[k] eine Spektralanalyse anzuwenden. Aus der ermittelten Spektralanalyse bzw. aus dem ermittelten Frequenzspektrum FFT kann herausgelesen werden, welche Frequenzanteile fi das Analog-Signal xa(t) beinhaltet, und anhand eines Vergleichs mit den auftretenden Frequenzanteilen fi und bekannten Schadfrequenzen fs in einen Vergleichsmittel 21 kann auf eine Störung der Vorrichtung 1 geschlossen werden.

Erfindungsgemäß ist nun in der Baugruppe 10 ein Detektionsmittel 13 vorhanden, welches ausgestaltet ist, für den Fall, dass das zu einem Abtastzeitpunkt ts über den Messbereich MB hinausgehende Analog-Signal xa(t) im Digital-Signal xd[k] abgeschnitten wird, dieses Ereignis zu erfassen und in einem Zähler 14 als eine Anzahl Nsat hoch zu zählen.

Über eine Signalgüte-Auswerteeinrichtung 15 kann nun eine Signalgüte Q als Quotient aus der Anzahl Nsat zu einer Gesamtabtastzahl N innerhalb des Messintervalls Tn bereitgestellt werden. Weiterhin ist in der Baugruppe 10 ein Entscheidungsmittel 16 vorhanden, welches ausgestaltet ist anhand der Signalgüte Q zu beurteilen, ob die bekannten Schadfrequenzen fs noch aus den ermittelten Frequenzanteilen fi des Frequenzspektrums FFT erkennbar sind, obwohl es durch mögliche abgeschnittene Signalanteile zu zusätzlichen Übersteuerungsanteilen fk in dem Frequenzspektrum FFT gekommen ist.

Wird mit Hilfe der Signalgüte Q in dem Entscheidungsmittel 16 entschieden, dass die Schadfrequenzen fs noch aus dem ermittelten Frequenzanteilen fi ermittelbar sind, so wird ein Gültig-Signal 30 an eine Auswerteeinheit weitergegeben.

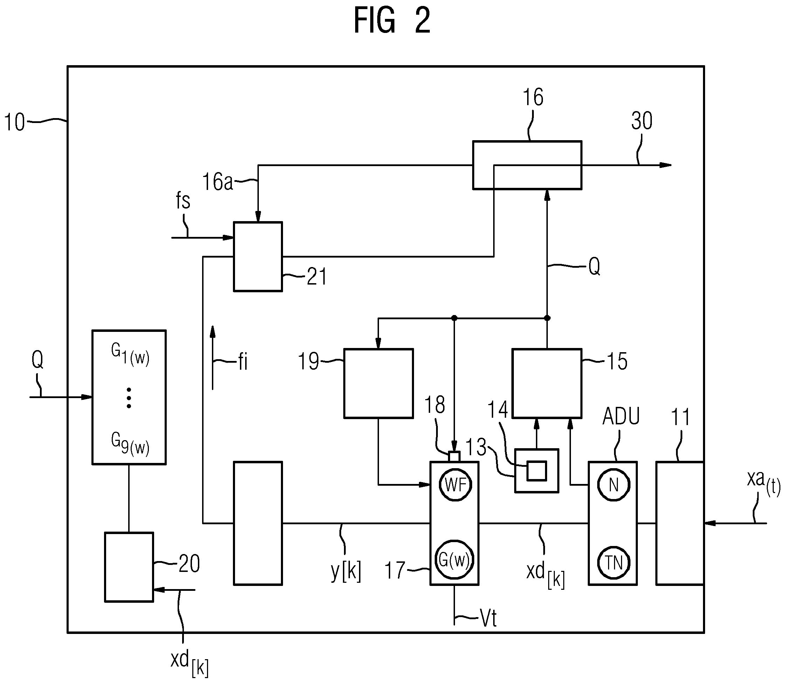

Die FIG 2 zeigt die in FIG 1 gezeigte Baugruppe 10 in einer Weiterbildung. Die Baugruppe 10 weist nun zusätzlich ein Filtermittel 17 auf, in welchen ein Signalkorrekturverfahren WF abläuft, welches das Digital-Signal xd[k] korrigiert bzw. schätzt und die durch das Abschneiden entstandene zusätzlichen Übersteuerungsanteile fk dadurch in einem Schätz-Signal y[k] eliminiert oder zumindest reduziert werden. Das Filtermittel 17 weist weiterhin eine Übertragungsfunktion G(w) auf, welche die bekannten Schadfrequenzen fs noch abbildet, wobei das Filtermittel 17 einen Eingang 18 für die Signalgüte Q aufweist und das Filtermittel 17 ausgestaltet ist, in Abhängigkeit von der Signalgüte Q die Übertragungsfunktion G(w) bis zu einen vorgebbaren Grenzwert Vt weiter zu nutzen.

Gemäß FIG 2 weist die Baugruppe 10 weiterhin ein Anpassungsmittel 19 auf, welches ausgestaltet ist in Abhängigkeit von der Signalgüte Q die Übertragungsfunktion G(w) zu modifizieren. Auch ist in der Ausgestaltungsvariante gemäß FIG 2 die Baugruppe 10 mit einem Lernmittel 20 versehen, welches ausgestaltet ist in einer Lernphase in einen Gutzustand der Vorrichtung 1 in Abhängigkeit von der Signalgüte Q eine Reihe von Übertragungsfunktionen Gj(w) zu bilden und zu archivieren. Weiterhin ist das Lernmittel 20 dazu ausgestaltet die Übertragungsfunktion P(w) im ursprünglichen Gutzustand einer überwachten Vorrichtung 1 als Referenz zu nehmen.

In dem Filtermittel 17 ist ein Wiener-Filter implementiert.

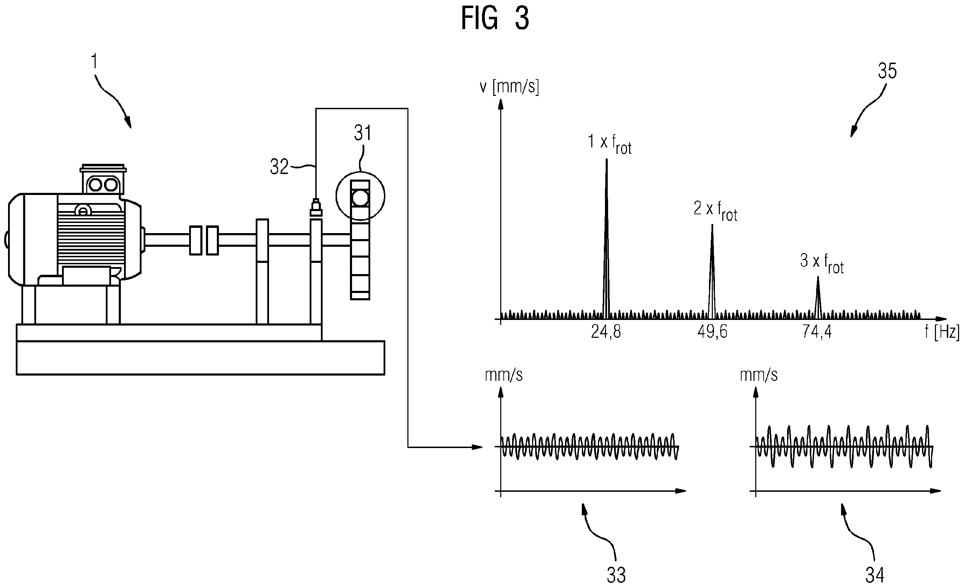

Mit der FIG 3 ist eine Zustandsüberwachung einer Vorrichtung 1 schematisch dargestellt. Die Vorrichtng 1 umfasst einen Motor mit einem Getriebe und einer Antriebswelle und einer Schwungmasse. Auf der Schwungmasse sitzt beispielsweise eine Unwucht 31. Über einen Sensor 32 wird eine Messung 33 im Gutzustand aufgenommen. Aufgrund der Unwucht 31 auf dem Schwungrad kann eine Messung 34 mit einer erhöhten Amplitude der Maschinenschwingung als Störung ermittelt werden. Das dazugehörige Spektrum 35 der Schwinggeschwindigkeiten zeigt drei unterschiedliche Frequenzanteile für drei unterschiedliche Rotationsfrequenzen.

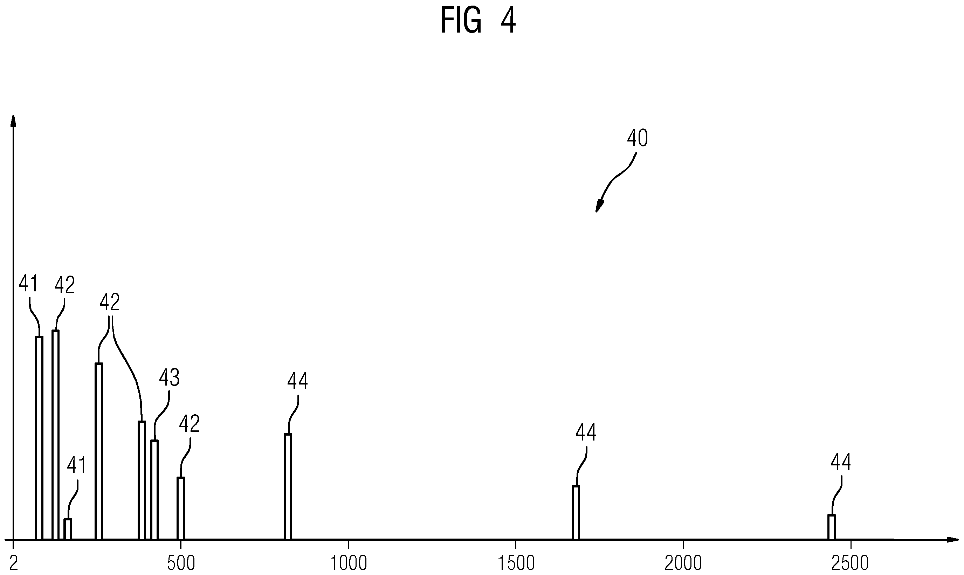

Mit der FIG 4 ist beispielhaft aufgezeigt, welche Fehler anhand von Schadfrequenzen auf ein Frequenzspektrum ermittelt werden können. So zeigt das Spektrum 40 mit Störfrequenzen bei den Stellen 41 einen Riemenfehler, bei den Stellen 42 einen Wälzlagerschaden, bei den Stellen 43 eine Schaufelpassierfrequenz und bei den Stellen 44 einen Zahneingriffsfehler.

Die FIG 5 zeigt von oben nach unten ein in die Begrenzung gehendes Rohsignal x'a(t), wobei in dem Signal-Verlauf x'a(t) der Messbereich MB eingezeichnet ist und sobald die Signalanteile des Rohsignals x'a(t) den Messbereich verlassen, werden diese abgeschnitten. Darunter ist die Signalgüte Q aufgetragen, welche mit zunehmenden Clipping von 100% nach 0% abnimmt. Umgekehrt proportional verhält sich darunter abgebildete Anzahl Nsat an geclippten Signalanteilen.

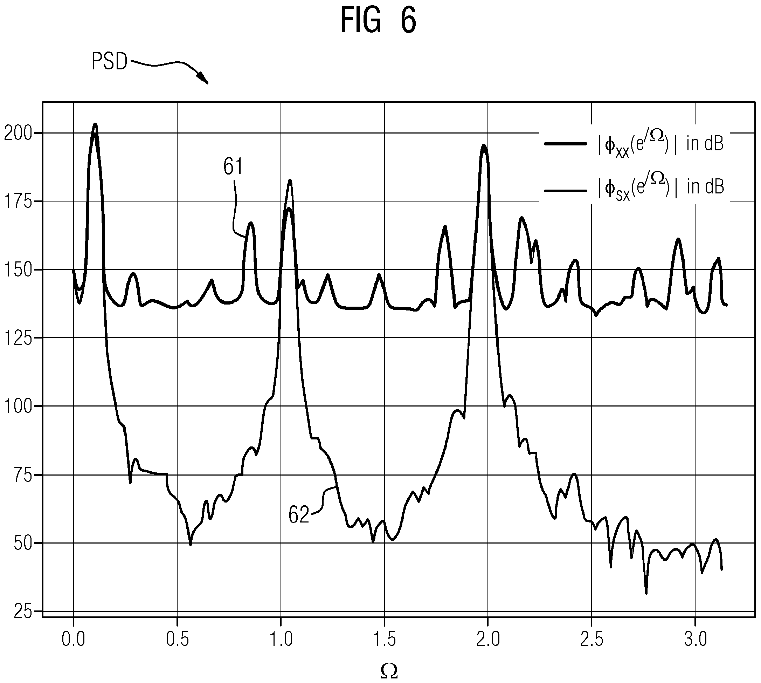

Die FIG 6 zeigt eine spektrale Leistungsdichte PSD, wobei in dem Diagramm zum einen die Leistungsdichte 61 für x mit x und zum anderen die Leistungsdichte 62 für x mit dem geclippten Signal abgebildet ist.

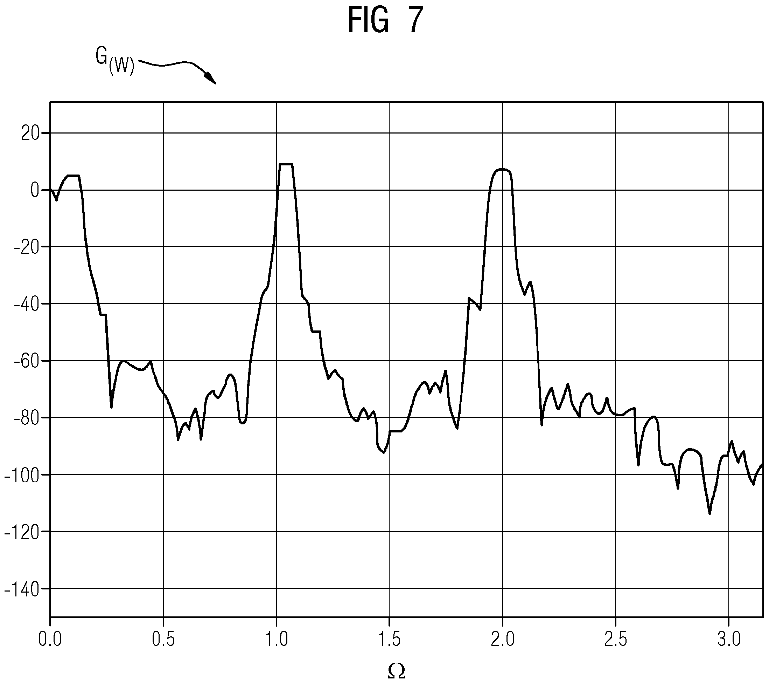

Die FIG 7 zeigt den aus den Verläufen der FIG 6 konstruierten Filter in seiner Überragungsfunktion nach Wiener. Clipping erzeugt vor allem bei hohen Frequenzen Spektrallinien mit Amplituden bis zu 10%. Dieses Verhalten, übertragen auf Lagerschadensanalysen bedeutet, dass Spektrallinien eingeblendet werden könnten, welche für einen Lagerschaden stehen. Es kommt entweder zu einer Fehlinterpretation ("falsch positiv"), oder aber ein Lagerschaden wird als schwerwiegender als er tatsächlich ist, eingestuft. Dies liegt daran, dass die vorhandenen Spektrallinien und Harmonischen von den Störanteilen die durch Klipping hervorgerufen werden, überlagert werden.

Das mit den Wiener-Filter aus dem Originalsignal gebildete geschätzte Signal besitzt nun fast ausschließlich die drei Hauptkomponenten des Originalsignals. Die Falsch-Anteile des geschätzten Signals liegen im Bereich < 1%, d.h. durch Clipping hervorgerufene Spektrallinien werden um 10⁻² unterdrückt und vorhandene Spektrallinien werden verbreitert. Das Wiener-Filter kann solange durch ständiges Mitberechnen der spektralen Leistungsdichte PSD von PSDxx und PSDXS unter daraus resultierenden Übertragungsfunktion optimiert werden, solange das erfindungsgemäße Maß Q, oder ein ähnliches an der Anzahl der gesättigten Messwerte eine Schwelle überschreitet.

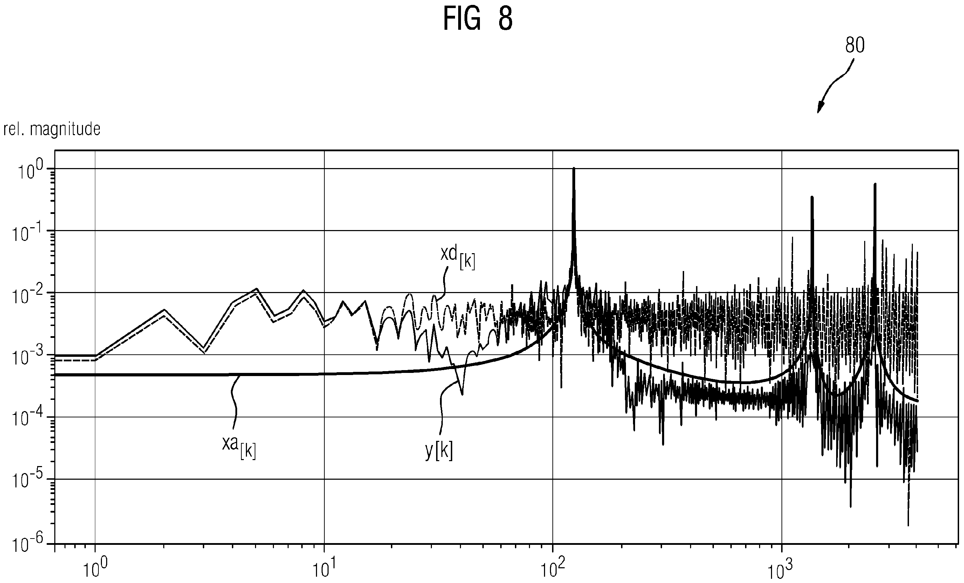

Mit der FIG 8 ist in einem FFT-Spektrum 80 ein Originalsignal Xa[k], ein beobachtetes Signal Xd[k], welches Clippinganteile enthält und das von Wiener-Filter geschätzte Signal y[k] dargestellt.

Das mit dem Wiener-Filter aus X geschätzte Signal Y besitzt fasst ausschließlich die drei Hauptkomponenten des Originalsignals. Die Falschanteile des geschätzten Signals liegen im Bereich von < 1%, d.h. durch Klipping hervorgerufene Spektrallinien werden in 10⁻² unterdrückt und vorhandene Spektrallinien werden verbreitert dargestellt.

## Patentansprüche

1. Verfahren zur Zustandsüberwachung einer Vorrichtung (1) durch eine Messung eines eine Schwingung der Vorrichtung (1) repräsentierendes zeit- und wert-kontinuierlichen Analog-Signals (xa(t)), wobei das Analog-Signal (xa(t)) zu Abtastzeitpunkten (ts) innerhalb eines Meßintervalls (TN) mit einem Analog-Digital-Umsetzer (ADU) in ein Digital-Signal (xd[k]) umgesetzt wird, wobei der Analog-Digital-Umsetzer (ADU) innerhalb eines Messbereichs (MB) betrieben wird, wobei für den Fall, dass das Analog-Signal (xa(t)) den Messbereich (MB) überschreitet, werden über den Messbereich (MB) hinausgehende Signalanteile des Analog-Signals (xa(t)) im Digital-Signal (xd[k]) abgeschnitten, wobei anschließend auf das Digital-Signal (xd[k]) eine Spektralanalyse angewendet wird, um zu ermitteln, welche Frequenzanteile (fi) das Analog-Signal (xa(t)) in einem Frequenzspektrum (FFT) umfasst, und anhand eines Vergleichs mit den auftretenden Frequenzanteilen (fi) und bekannten Schadfrequenzen (fs) auf eine Störung der Vorrichtung (1) zu schließen,
wobei für den Fall, dass zu einem Abtastzeitpunkt (ts) das über den Messbereich (MB) hinausgehende Analog-Signal (xa(t)) im Digital-Signal (xd[k]) abgeschnitten wird, dieses Ereignis erfasst wird, **dadurch gekennzeichnet, dass** dieses Ereignis in einem Zähler (14) als eine Anzahl (NSat) hochgezählt wird, wobei eine Signalgüte (Q) als Quotient aus der Anzahl (NSat) zu einer Gesamtabtastzahl (N) innerhalb des Meßintervalls (TN) bereitgestellt wird und die Signalgüte (Q) dazu verwendet wird zu beurteilen, ob die bekannten Schadfrequenzen (fs) noch aus den ermittelten Frequenzanteilen (fi) des Frequenzspektrums (FFT) erkennbar sind, obwohl es durch mögliche abgeschnittene Signalanteile zu zusätzlichen Übersteuerungsanteile (fk) in dem Frequenzspektrum gekommen ist.

2. Verfahren nach Anspruch 1, wobei mit einem Signalkorrekturverfahren (WF) das Digital-Signal (xd[k]) korrigiert bzw. geschätzt wird und die durch das Abschneiden entstandenen zusätzlichen Übersteuerungsanteile (fk) dadurch in einem Schätz-Signal (y[k]) eliminiert oder zumindest reduziert werden, wobei die bekannten Frequenzen, welche zu Fehlern und/oder Schäden geführt haben noch erkannt werden und in einer Übertragungsfunktion (G(w)) abgebildet werden, wobei in Abhängigkeit von der Signalgüte (Q) die Übertragungsfunktion (G(w)) bis zu einem vorgebbaren Grenzwert (Vt) von der Signalgüte (Q) weiter genutzt wird.

3. Verfahren nach Anspruch 2, wobei in Abhängigkeit von der Signalgüte (Q) die Übertragungsfunktion (G_{(w)}) modifiziert wird.

4. Verfahren nach Anspruch 2 oder 3, wobei in einer Lernphase in einem Gutzustand der Vorrichtung (1) in Abhängigkeit von der Signalgüte (Q) eine Reihe von Übertragungsfunktionen (Gj(w)) gebildet und archiviert werden, wobei dann die Übertragungsfunktion (Gj(w)) im ursprünglichen Gutzustand einer überwachten Vorrichtung als Referenz dient.

5. Verfahren nach einem der Ansprüche 2 bis 4, wobei als Signalkorrekturverfahren (WF) ein Wiener-Filter verwendet wird.

6. Elektronische Baugruppe (10) ausgestaltet zur Zustandsüberwachung einer Vorrichtung (1) umfassend
- eine Eingangsschaltung (11) zur Messung eines eine Zustandsgröße der Vorrichtung (1) repräsentierendes zeit- und wert-kontinuierlichen Analog-Signals (xa(t)),
- einen Analog-Digital-Umsetzer (ADU), welcher das Analog-Signal (xa(t)) zu Abtastzeitpunkten (ts) innerhalb eines Meßintervalls (TN) abtastet und in ein Digital-Signal (xd[k]) umsetzt, wobei der Analog-Digital-Umsetzer (ADU) ausgestaltet ist, innerhalb eines Messbereichs (MB), wobei für den Fall, dass das Analog-Signal (xa(t)) den Messbereich (MB) überschreitet, über den Messbereich (MB) hinausgehende Signalanteile des Analog-Signals (xa(t)) im Digital-Signal (xd[k]) abzuschneiden,
- ein Mittel (12) zur Spektralanalyse um auf das Digital-Signal (xd[k]) eine Spektralanalyse anzuwenden, um zu ermitteln, welche Frequenzanteile (fi) das Analog-Signal (xa(t)) in einem Frequenzspektrum (FFT) umfasst, und anhand eines Vergleichs mit den auftretenden Frequenzanteilen (fi) und bekannten Schadfrequenzen (fs) auf eine Störung der Vorrichtung (1) zu schließen, wobei
- ein Detektionsmittel (13) vorhanden ist, welches ausgestaltet ist, für den Fall, dass das zu einem Abtastzeitpunkt (ts) über den Messbereich (MB) hinausgehende Analog-Signal (xa(t)) im Digital-Signal (xd[k]) abgeschnitten wird, dieses Ereignis zu erfassen **dadurch gekennzeichnet, dass** das Detektionsmittel (13) ausgestaltet ist dieses Ereignis in einem Zähler (14) als eine Anzahl (NSat) hochzuzählen,
- wobei eine Signalgüte-Auswerteeinrichtung (15) vorhanden ist, welche eine Signalgüte (Q) als Quotient aus der Anzahl (NSat) zu einer Gesamtabtastzahl (N) innerhalb des Meßintervalls (TN) bereitstellt,
- weiterhin aufweisend ein Entscheidungsmittel (16), welches ausgestaltet ist, anhand der Signalgüte (Q) zu beurteilen, ob die bekannten Schadfrequenzen (fs) noch aus den ermittelten Frequenzanteilen (fi) des Frequenzspektrums (FFT) erkennbar sind, obwohl es durch mögliche abgeschnittene Signalanteile zu zusätzlichen Übersteuerungsanteilen (fk) in dem Frequenzspektrum (FFT) gekommen ist.

7. Baugruppe (10) nach Anspruch 6, weiterhin aufweisend ein Filtermittel (17), in welchem ein Signalkorrekturverfahren (WF) abläuft, welches das Digital-Signal (xd[k]) korrigiert bzw. schätzt und die durch das Abschneiden entstandenen zusätzlichen Übersteuerungsanteile (fk) dadurch in einem Schätz-Signal (y[k]) eliminiert oder zumindest reduziert werden, wobei das Filtermittel (17) weiterhin eine Übertragungsfunktion (G(w)) aufweist, welche die bekannten Frequenzen, welche zu Fehlern und/oder Schäden geführt haben, noch abbildet, wobei das Filtermittel (17) einen Eingang (18) für die Signalgüte (Q) aufweist und das Filtermittel (17) ausgestaltet ist, in Abhängigkeit von der Signalgüte (Q) die Übertragungsfunktion (G(w)) bis zu einem vorgebbaren Grenzwert (Vt) weiter zu nutzen.

8. Baugruppe (10) nach Anspruch 7, mit einem Anpassungsmittel (19), welches ausgestaltet ist in Abhängigkeit von der Signalgüte (Q) die Übertragungsfunktion (G(w)) zu modifizieren.

9. Baugruppe (10) nach Anspruch 7 oder 8, mit einem Lernmittel (20), welches ausgestaltet ist in einer Lernphase in einem Gutzustand der Vorrichtung (1) in Abhängigkeit von der Signalgüte (Q) eine Reihe von Übertragungsfunktionen (Gj(w)) zu bilden und zu archivieren, weiterhin ausgestaltet die Übertragungsfunktion (G(w)) im ursprünglichen Gutzustand einer überwachten Vorrichtung (1) als Referenz zu nehmen.

10. Baugruppe (10) nach Anspruch 7 bis 9, wobei in dem Filtermittel (17) ein Wiener-Filter implementiert ist.

## Claims

1. Method for monitoring the status of an apparatus (1) by measuring an analogue signal (xa(t)) which is continuous in terms of time and value and represents a vibration of the apparatus (1), wherein the analogue signal (xa(t)), at scanning times (ts) within a measuring interval (TN), is converted into a digital signal (xd[k]) with an analogue-digital converter (ADU), wherein the analogue-digital converter (ADU) is operated within a measuring range (MB), wherein in the event that the analogue signal (xa(t)) exceeds the measuring range (MB), signal portions of the analogue signal (xa(t)) which extend beyond the measuring range (MB) are cut in the digital signal (xd[k]), wherein a spectral analysis is then applied to the digital signal (xd[k]) in order to determine which frequency portions (fi) the analogue signal (xa(t)) comprises in a frequency spectrum (FFT), and to conclude a malfunction of the apparatus (1) on the basis of a comparison with the occurring frequency portions (fi) and known damage frequencies (fs),
wherein
in the event that at a scanning time (ts) the analogue signal (xa(t)) which extends beyond the measuring range (MB) is cut in the digital signal (xd[k]), this event is detected, **characterised in that** this event is incremented in a counter (14) as a number (NSat), wherein a signal quality (Q) is provided as a quotient from the number (NSat) relating to an overall scanning number (N) within the measuring interval (TN), and the signal quality (Q) is used to assess whether the known damage frequencies (fs) can still be identified from the determined frequency portions (fi) of the frequency spectrum (FFT), although additional overcontrol portions (fk) occur in the frequency spectrum as a result of possibly cut signal portions.

2. Method according to claim 1, wherein the digital signal (xd[k]) is corrected or estimated with a signal correction method (WF) and the additional overcontrol portions (fk) produced by the cutting are as a result eliminated or at least reduced in an estimate signal (y[k]), wherein the known frequencies which have resulted in errors and/or damage are still identified and mapped in a transfer function (G(w)), wherein as a function of the signal quality (Q) the transfer function (G(w)) is used further up to a predeterminable limit value (Vt) of the signal quality (Q).

3. Method according to claim 2, wherein the transfer function (G_{(w)}) is modified as a function of the signal quality (Q).

4. Method according to claim 2 or 3, wherein a series of transfer functions (Gj(w)) are formed and archived in a learning phase in a quality state of the apparatus (1) as a function of the signal quality (Q), wherein the transfer function (Gj(w)) is then used as a reference in the original quality state of a monitored apparatus.

5. Method according to one of claims 2 to 4, wherein a Wiener filter is used as a signal correction method (WF).

6. Electronic assembly (10) designed to monitor the status of an apparatus (1) comprising
- an input circuit (11) for measuring an analogue signal (xa(t)) which is continuous in terms of time and value and represents a status variable of the apparatus (1),
- an analogue-digital converter (ADU) which scans the analogue signal (xa(t)) at scanning times (ts) within a measuring interval (TN) and converts the same into a digital signal (xd[k]), wherein the analogue-digital converter (ADU) is designed, within a measuring range (MB), wherein in the event that the analogue signal (xa(t)) exceeds the measuring range (MB), to cut signal portions, extending beyond the measuring range (MB), of the analogue signal (xa(t)) in the digital signal (xd[k]),
- a means (12) for spectral analysis in order to apply a spectral analysis to the digital signal (xd[k]), in order to determine which frequency portions (fi) the analogue signal (xa(t)) comprises in a frequency spectrum (FFT) and on the basis of a comparison with the occurring frequency portions (fi) and known damage frequencies (fs) to conclude a malfunction of the apparatus (1),
wherein
- a detection means (13) is available, which is designed, in the event that the analogue signal (xa(t)) which extends beyond the measuring range (MB) at a scanning point (ts) is cut in the digital signal (xd[k]), to detect this event, **characterised in that** the detection means is designed to increment this event in a counter (14) as a number (NSat),
- wherein a signal quality evaluation facility (15) is available, which provides a signal quality (Q) as a quotient from the number (NSat) relating to an overall scanning number (N) within the measuring interval (TN),
- furthermore having a decision means (16), which is designed to assess, on the basis of the signal quality (Q), whether the known damage frequencies (fS) can still be identified from the determined frequency portions (fi) of the frequency spectrum (FFT), although additional overcontrol portions (fk) result in the frequency spectrum (FFT) as result of possible cut signal portions.

7. Assembly (10) according to claim 6, further having a filter means (17), in which a signal correction method (WF) runs, which corrects or estimates the digital signal (xd[k]) and which are eliminated or at least reduced by the cutting of developed additional overcontrol portions (fk) as a result in an estimate signal (y[k]), wherein the filter means (17) further has a transfer function (G(w)), which still maps the known frequencies (fs), which have resulted in errors and/or damage, wherein the filter means (17) has an input (18) for the signal quality (Q) and the filter means (17) is designed to further use the transfer function (G(w)) up to a predeterminable limit value (Vt) as a function of the signal quality (Q).

8. Assembly (10) according to claim 7, with an adjustment means (19), which is designed to modify the transfer function (G(w)) as a function of the signal quality (Q).

9. Assembly (10) according to claim 7 or 8, with a learning means (20), which, as a function of the signal quality (Q), is designed to form and archive a series of transfer functions (Gj(w)) in a learning phase in a quality state of the apparatus (1), is further designed to take as reference the transfer function (G(w)) in the original quality state of a monitored apparatus (1).

10. Assembly (10) according to claim 7 to 9, wherein a Wiener filter is implemented in the filter means (17).

## Revendications

1. Procédé de contrôle de l'état d'une installation (1) par une mesure d'un signal (xa(t)) analogique se continuant dans le temps et en valeur représentant une vibration de l'installation (1), dans lequel on transforme le signal (xa(t)) analogique à des instants (ts) d'échantillonnage dans un intervalle (TN) de mesure, par un convertisseur (ADU) analogique-numérique en un signal (xd[k]) numérique, dans lequel on fait fonctionner le convertisseur (ADU) analogique-numérique dans une plage (MB) de mesure, dans lequel, dans le cas où le signal (xa(t)) analogique dépasse la plage (MB) de mesure, on découpe dans le signal (xd[k]) numérique des composantes, allant au-delà de la plage (MB) de mesure, du signal (xa(t)) analogique, dans lequel on applique ensuite une analyse spectrale au signal (xd[k]) numérique pour trouver les composantes (fi) de fréquence, que le signal (xa(t)) analogique a dans un spectre (FFT) de fréquence, et à l'aide d'une comparaison avec les composantes (fi) de fréquence qui apparaissent et des fréquences (fs) de dommage connues, on décide d'une perturbation de l'installation (1),
dans lequel, dans le cas où, à un instant (ts) d'échantillonnage, on découpe, dans le signal (xd[k]) numérique, le signal (xa(t)) analogique allant au-delà de la plage (MB) de mesure, on détecte cet événement, **caractérisé en ce que** l'on compte cet événement dans un compteur (14) sous la forme d'un nombre (NSat), dans lequel on dispose d'une qualité (Q) du signal sous la forme du quotient du nombre (NSat) à un nombre (N) d'échantillonnage total dans l'intervalle (TN) de mesure et on utilise la qualité (Q) du signal pour décider, si les fréquences (fs) de perturbation connues peuvent être encore détectées à partir des composantes (fi) de fréquence déterminées du spectre (FFT) de fréquence, bien que cela se produise par des composantes de signal éventuelles découpées en des composantes (fk) supplémentaires de surmodulation dans le spectre de fréquence.

2. Procédé suivant la revendication 1, dans lequel, par un procédé (WF) de correction de signal, on corrige et on évalue le signal (xd[k]) numérique et on élimine ou du moins on réduit dans un signal (y[k]) d'évaluation, les composantes (fk) supplémentaires de surmodulation créées par la découpe, dans lequel on détecte encore les fréquences connues, qui ont conduit à des défauts et/ou des dommages et on les représente sous la forme d'une fonction (G(w)) de transfert, dans lequel, en fonction de la qualité (Q) du signal, on continue à utiliser la fonction (G(w)) de transfert jusqu'à une valeur (Vt) limite pouvant être donnée à l'avance de la qualité (Q) du signal.

3. Procédé suivant la revendication 2, dans lequel on modifie la fonction (G(w)) de transfert en fonction de la qualité (Q) du signal.

4. Procédé suivant la revendication 2 ou 3, dans lequel dans une phase d'apprentissage, alors que l'installation (1) est en bon état, on forme et on archive une série de fonctions (Gj(w)) de transfert, en fonction de qualité (Q) du signal, dans lequel la fonction (Gj(w)) de transfert dans le bon état d'origine d'une installation contrôlée sert de référence.

5. Procédé suivant l'une des revendications 2 à 4, dans lequel on utilise un filtre de Wiener comme procédé (WF) de correction du signal.

6. Module (10) électronique conformé pour contrôler l'état d'une installation (1) comprenant :
- un montage (11) d'entrée pour la mesure d'un signal (xa(t)) analogique continu dans le temps et en valeur représentant une grandeur d'état de l'installation (1),
- un convertisseur (ADU) analogique-numérique, qui échantillonne le signal (xa(t)) analogique à des instants (ts) d'échantillonnage dans un intervalle (TN) de mesure et le transforme en un signal (xd[k]) numérique, dans lequel le convertisseur (ADU) analogique-numérique est conformé pour, dans une plage (MB) de mesure, dans le cas où le signal (xa(t)) analogique dépasse la plage (MB) de mesure, découper dans le signal (xd[k]) numérique, des composantes, allant au-delà de la plage (MB) de mesure, du signal (xa(t)) analogique,
- un moyen (12) d'analyse spectrale afin d'appliquer au signal (xd[k]) numérique une analyse spectrale, afin de déterminer les composantes (fi) de fréquence que le signal (xa(t)) analogique comprend dans un spectre (FFT) de fréquence et, à l'aide d'une comparaison avec les composantes (fi) de fréquence qui se produisent et des fréquences (fs) de dommage connues, décider d'une perturbation de l'installation (1),
dans lequel
- il y a un moyen (13) de détection qui est conformé pour, dans le cas où on découpe dans le signal (xd[k]) numérique, le signal (xa(t)) analogique allant au-delà de la plage (MB) de mesure à un instant (ts) d'échantillonnage, détecter cet événement, **caractérisé en ce que** le moyen (13) de détection est conformé pour compter cet événement dans un compteur (14) sous la forme d'un nombre (NSat),
- dans lequel il y a un dispositif (15) d'évaluation de la qualité du signal, qui met à disposition une qualité (Q) du signal sous la forme d'un quotient du nombre (NSat) par un nombre (N) d'échantillonnage total dans l'intervalle (TN) de mesure,
- comportant, en outre, un moyen (16) de décision, qui est conformé pour juger à l'aide de la qualité (Q) du signal, si les fréquences (fs) de dommage connues peuvent être détectées encore à partir des composantes (fi) de fréquence déterminées du spectre (FFT) de fréquence, bien qu'il se produise par des composantes du signal possibles découpées en des composantes (fk) supplémentaires de surmodulation dans le spectre (FFT) de fréquence.

7. Module (10) suivant la revendication 6, comportant, en outre, un moyen (17) de filtrage, dans lequel se déroule un procédé (WF) de correction du signal, qui corrige et évalue le signal (xd[k]) numérique et élimine les composantes (fk) supplémentaires de surmodulation créées par la découpe, ainsi en un signal (y[k]) d'évaluation ou du moins les réduit, dans lequel le moyen (17) de filtrage a, en outre, une fonction (G(w)) de transfert, qui représente encore les fréquences connues, qui ont conduit à des défauts et/ou à des dommages, dans lequel le moyen (17) de filtrage a une entrée (18) pour la qualité (Q) du signal et le moyen (17) de filtrage est conformé pour, en fonction de la qualité (Q) du signal, continuer à utiliser la fonction (G(w)) de transfert jusqu'à une valeur (Vt) limite donnée à l'avance.

8. Module (10) suivant la revendication 7, comprenant un moyen (19) d'adaptation, qui est conçu pour modifier la fonction (G(w)) de transfert, en fonction de la qualité (Q) du signal.

9. Module (10) suivant la revendication 7 ou 8, comprenant un moyen (20) d'apprentissage, qui est conformé pour former dans une phase d'apprentissage alors que l'installation (1) est en bon état, en fonction de la qualité (Q) du signal, une série de fonctions (Gj(w)) de transfert et les archiver, en étant conformé en outre pour prendre comme référence la fonction (G(w)) de transfert dans le bon état d'origine d'une installation (1) contrôlée.

10. Module (10) suivant la revendication 7 à 9, dans lequel un filtre de Wiener est mis en œuvre dans le moyen (17) de filtrage.
